Europäisches Patentamt

European Patent Office

Office européen des brevets

(11) Publication number: **0 267 807**
**A2**

# EUROPEAN PATENT APPLICATION

(21) Application number: 87310066.3

(22) Date of filing: 13.11.87

(51) Int. Cl.⁴: **G 03 F 7/02**

(30) Priority: 14.11.86 US 931396

(43) Date of publication of application:
18.05.88 Bulletin 88/20

(84) Designated Contracting States:
AT BE CH DE FR GB IT LI NL SE

(71) Applicant: **MORTON THIOKOL, INC.**
**110 North Wacker Drive**
**Chicago Illinois 60606-1560 (US)**

(72) Inventor: **Chang, Shing Kang**
**13230 Warren Avenue**
**Los Angeles California 90066 (US)**

**Roos, Leo**
**1404 Morningside Drive**
**Laguna Beach California 92651 (US)**

(74) Representative: **Bankes, Stephen C. D. et al**
**Baron & Warren 18 South End Kensington**
**London W8 5BU (GB)**

(54) Improved photosensitive laminate.

(57) A photosensitive laminate (L,L') is produced by laminating a photoresist layer (3), an intermediate film (2) adhered thereto comprising from 10 to 100wt% of carboxylated polyvinyl alcohol and 0.90wt% of hydroxyethyl cellulose, and a support sheet (1) of a material which adheres to the intermediate film but with relatively less adhesion than that between the intermediate film and the photoresist layer. Such laminates can be applied to one or both sides of a metal-clad substrate (5) for a printed circuit board for the production of a circuit pattern thereon by patterned irradiation and subsequent development.

Fig. 2

EP 0 267 807 A2

**Description**

IMPROVED PHOTOSENSITIVE LAMINATE

The present invention relates to laminate compositions, including a laminate of light-sensitive photoresist useful in producing printed circuits, high-resolution applications of the like plus protective support layers.

BACKGROUND OF THE INVENTION

Photosensitive resists are used in processes involving the formulation of printed circuit boards, photolithographs, nameplates or the like. In one typical process for the formation of a printed circuit board, a metal-clad substrate sheet is coated with a negative acting photoresist composition, and the photoresist is exposed to patterned radiation produced by shining visible or non-visible light through a positive or negative of the desired image. The light-exposed areas of the resist are rendered insoluble, e.g., by polymerization or cross-linking, by exposure to actinic radiation, and then the exposed resist is washed with a developer to remove unexposed, soluble resist portions and thereby leave patterned portions of the underlying metal layer exposed. An etch to which the resist is impervious is used to etch away the exposed metal. The remaining resist may or may not be removed, as desired. Alternatively, a non-metal substrate covered with an exposed and developed photoresist may be selectively plated with metal to provided a metal layer of the desired image pattern.

U.S. Patent No. 4,530,896 issued 23 July 1985 to Christensen et al., the teachings of which are incorporated herein by reference, describes in substantial detail recent developments in applying a photoresist layer or a photoresist layer-containing laminate to a base or substrate sheet.

U.S. Patent No. 4,530,896 is directed to an improved photoresist laminate in which a transparent intermediate layer or film is interposed between a photoresist layer and a backing or support sheet. The intermediate film is selectively adherent to the resist layer relative to its adherence to the support sheet, whereby the resist layer may be adhered to the substrate, e.g., by heat and/or pressure, and the support sheet contemporaneously removed, providing a composite of substrate, resist, and intermediate film in which the intermediate film serves as a protective top sheet over the photoresist layer. The intermediate film or top sheet, in addition to its selective adherence to the resist layer relative to its adherence to the support sheet, is selected for its transparency, strength, flexibility, and gas impermeability. Importantly, the intermediate film is formed of material that is further selected for its solubility in the intended developer, whereby the intermediate film, now serving as the protective top sheet, is removable along with developer-soluble portions of the resist layer (exposed or non-exposed portions, depending upon the chemical nature of the resist).

Three-layer laminates, such as are described in U.S. Patent No. 4,530,896, have not yet found widespread application in the production of printed circuit boards or the like. While desirable characteristics of an intermediate film (top sheet) material are recognized, many suggested materials are inadequate in one respect or another; for example, a material may lack sufficient mechanical strength, flexibility, selective adhesion or solubility in developer. U.S. Patent No. 4,530,896 suggests a variety of candidate materials for intermediate film (top sheet) use, including water-soluble salts of the group consisting of polyvinyl ether-maleic anhydride copolymers, water-soluble cellulose ethers, water-soluble salts of carboxyalkylcellulose, water-soluble salts of carboxyalkyl starch, polyvinyl alcohol, polyvinyl pyrrolidone, various polyacrylamides, various water-soluble polyamides, water-soluble salts of polyacrylic acid, gelatin, ethylene oxide polymers, various starches and the like.

Of the above-listed intermediate film materials, polyvinyl alcohol has had the most widespread commercial application, but with limited success. One major drawback is the tendency of PVA to increase in viscosity and to gel in the presence of high-ionic strength solutions, and thus many common developers, including basic developers, tend to gel PVA. Gelled PVA may stick to exposed portions of the etchable metal layer, resulting in printing errors. Gelled PVA also interferes with recycling of developer. Because of the insolubility problems experienced with PVA in the presence of basic developers, manufacturers of laminates which incorporate PVA intermediate layers recommend a pre-development step in which the PVA is removed from the photoresist prior to development (removal of base-soluble portions) of the photoresist layer. The need for the extra pre-development step is considered disadvantageous.

Not only does PVA tend to gel in the presence of high-ionic strength solutions, but organic solvents, such as alkyl cellulose, carbitols, isopropanol and ethanol, which are used in developers in conjunction with ionic aqueous solutions, also tend to gel PVA.

Above-identified U.S. Patent No. 4,530,896 describes intermediate film materials, such as PVA, as having selective adhesion to commonly used resist layer materials relative to commonly used support sheet materials. Although this is true of PVA, a problem with PVA as an intermediate film is that its adherence at room temperature to commonly used support sheet materials such as polyester or cellulose acetate, is often inadequate, and premature separation of a support sheet from a PVA film may occur. On the other hand, at elevated temperatures whereat the laminate is applied to a substrate so as to adhere the photoresist to the substrate surface, PVA tends to stick tightly to support sheet materials, and an attempt to remove the support sheet, as is desired for certain applications, may damage the PVA layer.

There exists a need for improved photoresist-containing laminates, and in particular for improved materials to act as an intermediate film between a removable support sheet and a photoresist layer.

## 0 267 807

## SUMMARY OF THE INVENTION

In accordance with the invention, an improved photosensitive laminate comprises a photoresist layer, a removable support sheet and an interposed intermediate film that is either carboxylated polyvinyl alcohol (CPVA) or a composite mixture of CPVA and hydroxyethyl cellulose (HEC). These materials are selectively adherent to a variety of aqueous and semi-aqueous resist materials relative to a variety of support sheet materials, particularly surface-treated polyester support sheets having appropriately high wetting angles. CPVA and CPVA/HEC materials are readily soluble in basic developers and therefore are removed during developing of a base-developable resist.

In accordance with a preferred aspect of the invention, the support sheet material is a polyester, such as a polyethylene terephthalate (PET), to which the CPVA or the CPVA/HEC composite adheres, but to a substantially lesser degree than the CPVA or the CPVA/HEC composite adheres to commonly used resists, particularly those which are developable by basic aqueous or semi-aqueous solutions.

For use in an etching process, the laminate is adhered to a substrate in one manner or another. The support sheet is peeled from the intermediate film, whereupon the intermediate film becomes a top sheet covering and protecting the photoresist layer and underlying layers of the substrate.

## BRIEF DESCRIPTION OF THE DRAWINGS

Fig. 1 is an enlarged cross-sectional view of a photosensitive laminate in accordance with a preferred embodiment of the invention;

Fig. 2 is a diagrammatic representation of apparatus used for applying laminate, such as described in accordance with the invention, to a two-sided substrate; the substrate and laminate at the right-hand side of the figure being shown greatly enlarged relative to the apparatus and laminate at the left-hand side of the drawing;

Fig. 3 is an enlarged cross-sectional view of the composite produced by the apparatus of Figure 2; and

Fig. 4 is an enlarged cross-sectional view of a laminate representing an alternative embodiment of the present invention.

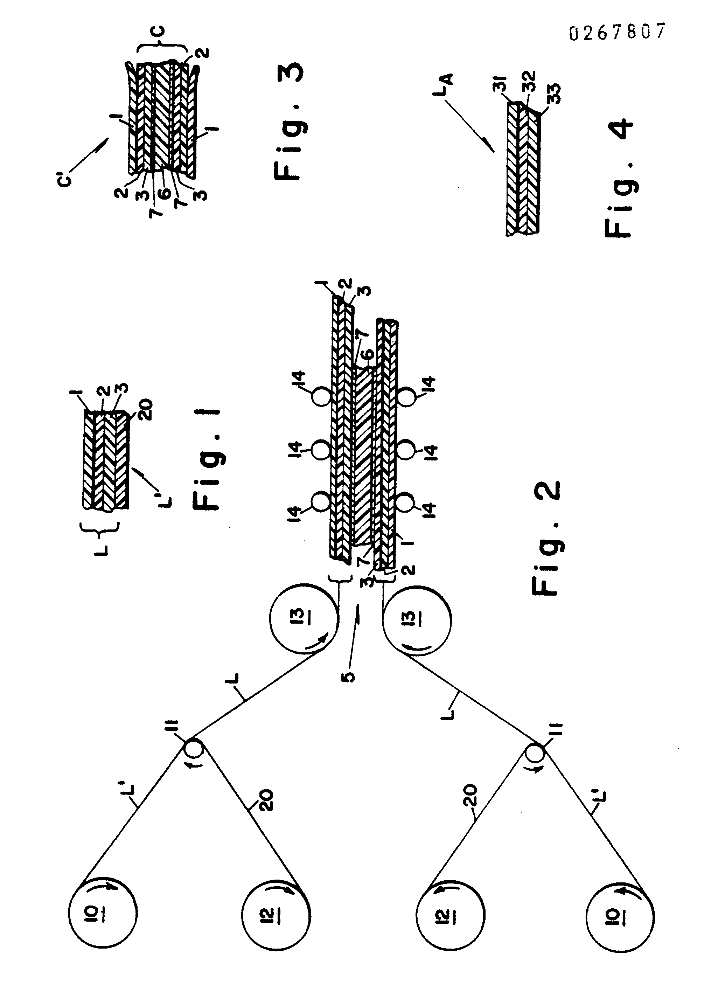

(The laminates and compositions in Figs. 1-4 are not drawn to scale.)

## DETAILED DESCRIPTION OF CERTAIN PREFERRED EMBODIMENTS

In Fig. 1 of the drawings, there is illustrated a laminate L which comprises a support sheet 1, an intermediate protective layer or film 2, and a light-sensitive or photoresist layer 3. The support sheet 1 acts to protect the underlying layers, to provide body to the laminate L that enables it to be provided in roll form prior to application to a substrate, and to separate multiple layers of the laminate, e.g., when in a roll.

The laminate, as illustrated in Figure 1, also has an optional, temporary cover sheet 20 which is removably adherent to the resist layer (the laminate L along with the cover sheet 20 is designated L' in Fig. 1). The cover sheet 20 protects the resist layers from dust and abrasion and prevents interaction of the resist layer 3 and support sheet 1 when in roll form. The cover sheet 20 is removed prior to applying the resist side of the laminate L to a substrate. To facilitate removal of the cover sheet 20 from the resist layer 3, the cover sheet is formed of a hydroprobic material, such as polyethylene.

The support sheet 1 is selected from polymeric materials to which the intermediate film materials in accordance with the invention adhere, but with relatively less adherence than the adherence of the intermediate film materials to the photoresist materials. Suitable support sheet materials include, but are not limited to polyamides, polyolefins, polyesters, vinylpolymers and cellulose esters. Preferred support sheet materials are polyesters, and a particularly preferred support sheet material is polyethylene terephthalate (PET), such as that sold under the tradename Mylar. PET, if used, is preferably surface-treated to provide adequate hydrophilicity or wetting angle. The support sheet might also be paper that is coated with an appropriate release agent, such as silicone. The thickness of the support sheet is not critical and typically may vary between 0.9 and 4 mils.

The photoresist layer 3 comprises a light-sensitive resist material in a polymeric binder. The intermediate films which are the subject of the present invention are particularly advantageous with respect to negative acting, photopolymerizable photoresists. Such resist materials polymerize upon exposure to light and become insoluble in developer that dissolves unexposed portions. The excellent oxygen impermeability of the intermediate film materials of the present invention are particularly important with respect to negative acting, polymerizable photoresists. The invention, however, is intended to include laminates having other types of resists, including negative acting/cross-linking resists and positive acting resists, as are known in the art.

Examples of suitable negative acting, polymerizable photoresists are found, for example, in U.S. Patent No. 4,528,261 issued 9 July 1985 to W. P. Hauser, the teachings of which are incorporated herein by reference. Useful photopolymerizable resists are described in U.S. Patent No. 4,539,286 issued 3 September 1985 to M. A. Lipson et al.

The intermediate film of the present invention has particular advantage with respect to basic-aqueous and semi-aqueous developers, being soluble in aqueous and semi-aqueous solutions, including basic aqueous and semi-aqueous solutions, and is therefore removed during development of the resist layer with a basic aqueous or semi-aqueous developer. When using a basic developer, therefore, there is no need for a pre-development step. This contrasts with PVA which is soluble in essentially neutral aqueous solutions but

3

tends to gell in basic solutions. It is, of course, contemplated that the intermediate film be used in conjunction with a solvent-developable resist, in which case, the intermediate film would be dissolved in a pre-development step with an aqueous solution.

Included in a resist composition is a binder comprised of resin or a combination of resins as is known in the art, for example, the combination of an acrylic resin with a styrene/maleic anhydride resin.

The thickness of the resist layer in dry film form is not critical, but it is desired that the resist layer by thin for image quality, high-resolution and low cost. Consequently, a maximum thickness is generally about 4.0 mils, and preferably, the maximum thickness is less than about 2.0 mils. Although the resist layer conceivably is as low as about 0.1 mil; practically, resist layers are generally about over 0.5 mils or above.

The intermediate film 2 is intended to act as a protective film or top sheet for the photoresist layer 3 after the laminate is adhered to a substrate and the support layer 1 is stripped therefrom. As such, it should provide a smooth, flat surface. As the resist 3 is exposed through the top sheet 2, the top sheet must be optically transmitting in the actinic region and be formed of a material that is soluble in a developer which is a non-solvent for the portions of the photoresist not to be removed. for purposes of this invention, the intermediate film should be soluble in a basic aqueous developer so that following exposure, the intermediate film is removed by a simple washing operation that, in the case of a base-developable resists, also develops the photoresist.

The method of forming the light-sensitive laminate of the invention is in accord with known procedures, such as by roller coating or spraying solutions or dispersions of the materials of the intermediate film and then the resist onto the support layer.

FIG. 2 illustrates typical laminating apparatus which is used to apply photoresist laminates continuously to pre-cut substrates 5 for printed circuit boards, semiconductor parts, nameplates or the like. The substrate 5 typically comprises metals, ceramics, plastics or semiconductor materials. For printed circuit board manufacture using a subtractive process, the substrate 5 typically comprises a layer of plastic 6, e.g., phenolic or epoxy, that is clad with a layer of metal 7, e.g., copper foil. The illustrated substrate is two-sided, having metal foil 7 on both surfaces of the base material 6; the substrate 5 is shown being coated on each side with laminate L. Typically the foil layers 7 are cleaned prior to applying the laminate L, e.g., by scrubbing twice and drying at elevated temperatures. The present example of printed circuit board making, of course, does not exhaust the possible applications of the invention which finds use as well in the graphic arts, the making of decals and nameplates, chemical milling, etching and in any field in which a photoresist is to be put on a substrate made from whatever composition is expedient.

Laminate L' is provided on reels 10. At rollers 11, the cover sheets 20 are pealed away from the resist layers 3 and collected on take-up reels 12 while laminates L are fed to the substrate along rollers 13 with the resist layers 3 facing the foil layers 7. Upper and lower heated pressure rolls 14 press the laminates L to the substrate 5 and cause the light-sensitive resist layers 3 to become adhered to the foil layers 7. A suitable temperature for heat-bonding the laminates L to the substrates 5 may vary within rather broad limits, but temperatures of from 30°C to approximately 175°C are appropriate, depending upon the materials of the light-sensitive laminate. Preferably, the pressure rolls 14 are rubber-coated to prevent damage to the composite.

Excess laminate L is trimmed from along the edges of the substrate 5, producing a composite designated C' in Figure 3 in which the resist layers 3, intermediate films 2, and support sheets 1 are successively outward of the foil layers 7. As seen at the right-hand side of Figure 3, the support sheets 1 are peelable from the intermediate films 2 to provide a composite C in which the resist layers 3 and intermediate films 2 are successively outward of the substrate 5. Removal of the support sheet 1 is enabled by the selective adhesion of the intermediate film 2 to the photoresist 3, relative to its adhesion to the support sheet 1. The support sheet 1 may be removed any time after the laminate is applied to the substrate 5, but usually is removed just prior to exposure of the composite to actinic radiation.

In composite C, the intermediate film 2 becomes the top sheet which protects the photoresist 3 from dirt, ink, abrasion or the like and also from oxygen, which is especially damaging to polymerizable, negative acting resists. Furthermore, the top sheet 2 enables art work, e.g., a photonegative, to be placed over the composite C without the art work adhering to the photoresist. The top sheet 2 is transparent to actinic radiation, enabling the photoresist 3 to be exposed through the top sheet. A thin film of material which provides a protective top sheet 2 is advantageous for high-resolution applications relative to conventional dry-films in which a protective sheet, e.g., polyester, covers the resist during exposure. Protective sheets, particularly conventional polyester sheets, are relatively thick and reduce resolution by light scattering and light piping. In addition, polyester cover sheets reduce film speed. All of these problems are minimized by the use of a thin film top sheet in accordance with the invention from which the polyester sheet may be removed prior to exposure. Of course, the laminate of the present invention may be exposed without removal of the support sheet 1, but this reduces resolution and sensitivity.

Generally, the composite C is exposed by contact printing, i.e., by laying the art work directly on the top sheet 2 and exposing the composite to actinic light. With two-sided substrates, such as illustrated, different art work may be used to produce a different image on each side. Depending upon the type of resist layer used, either the exposed or the unexposed portion is soluble in basic aqueous solution while the remaining portion is insoluble in basic aqueous solution. The composite is then developed with a developer comprising a basic aqueous solution which removes both the water-soluble top sheet and the base-soluble portions of the photoresist layer, leaving the remaining base-insoluble portion of the photoresist layer covering the substrate. The developer may be a semi-aqueous basic solution further comprising a water-miscible organic solvent(s).

Subsequent to the above procedural steps, the surface(s) of the substrate can be treated with a suitable etch to form an etched surface(s). In alternative processes, the substrate can be plated or processed in other ways known to the art. The resist image can then be removed, if desired, by means of a stripper therefor with the aid of mechanical action, such as by rubbing, brushing and/or abrading, or by a combination of one or more of such steps as is known in the art.

In accordance with the present invention, an improved intermediate film 2 for a laminate L (which becomes the top sheet of a photosensitive composite C) is formed of carboxylated polyvinyl alcohol (CPVA) or a mixture of CPVA and hydroxyethyl cellulose (HEC). As required of a top sheet, these materials are transparent to actinic radiation, i.e., the light which is used to expose (e.g., cause polymerization or cross-linking) the photoresist, whereby the underlying photoresist layer is exposed through the top sheet. One important advantage of CPVA and CPVA/HEC mixtures relative to prior art materials is that these layers, while adhering adequately to a support sheet material to form a laminate, are selectively adherent to photoresist layers relative to most commonly used support sheet materials, and particularly so relative to polyester support sheets. The selective adherence of the intermediate film 2 to photoresist layers 3 helps to ensure that the support sheet 1 is easily peelable from the intermediate film of the laminate L after the laminate is adhered to the substrate 5 and peels from the intermediate film without damaging the intermediate film (top sheet) or without leaving residues of the support sheet on the top sheet.

Another important advantage of the materials used for the intermediate film of the laminate (which becomes the top sheet of the composite) is that the materials are readily soluble in basic developers, whereby if a base-developable resist is used, the exposed composite may be developed in one step without any prior chemical or mechanical removal of the top sheet. In this respect, the materials used in the intermediate film are advantageous relative to PVA which tends to gel and become somewhat insoluble in the presence of basic developing solutions. A typical basic developer comprises an aqueous solution of between about 0.5 and about 4 wt. percent sodium carbonate and/or potassium carbonate, although the invention is not intended to be limited in any manner to the use of particular basic aqueous developers. Basic developers are developing solutions having a pH of at least about 9.5.

Furthermore, the materials used for the intermediate film remain soluble in basic aqueous solutions even in the presence of organic solvents, such as alkyl cellulose, carbitols, isopropanol and ethanol. Thus, the basic developer may contain concentrations of water-miscible organic solvents. This contrasts with unmodified PVA which tends to gel and thereby become insoluble in the presence of organic solvents. CPVA and CPVA/HEC films are insoluble in hydrocarbons and are highly resistant barriers to oils, greases and organic solvents.

CPVA differs from PVA in that a small percentage, e.g., 1-5%, of the mer units have pendant carboxyl groups rather than pendant hydroxyl groups. Whereas PVA is formed by polymerizing vinyl acetate and then hydrolyzing the ester bonds of the resulting polyvinyl acetate; CPVA is a copolymer that is formed by copolymerizing vinyl acetate and an alkyl ester of acrylic acid and then hydrolyzing the ester bonds of the polymer. The hydrolyzed vinyl acetate residues provide pendant hydroxyl groups and the hydrolyzed acrylate ester residues provide the pendant carboxyl groups. Although for CPVA only a minor percentage of the vinyl mer units of PVA are replaced by acrylic mer units, the pendant carboxyl groups give the polymer substantially enhanced hydrophilicity relative to PVA and are found to represent a very substantial improvement for use in a top sheet relative to PVA. CPVA is hydrolyzed to at least about 75% and preferably to at least about 90%. 4 wt. percent solutions of CPVA useful in accordance with the present invention have viscosities ranging from about 5 to about 65 centipoise at 20°C and preferably between about 20 and about 40 centipoise. A suitable CPVA for use in accordance with the invention is sold under the trade designation Vinol-118M by Air Products.

CPVA films have excellent flexibility, high tensile strength and a high degree of impermeability to most gases, importantly for negative resists, including impermeability to oxygen. These characteristics are advantageous from the standpoint of enabling a very thin layer to be provided as the intermediate film in the laminate and to serve as the top sheet of the photosensitive composite. Thinness of a top sheet is highly desirable because a thin layer reduces optical distortion, such as diffraction and light scattering, and thereby enables a sharper image to be produced. Using intermediate film 0.1 mil or even thinner may provide adequate protection. Of course, thicker intermediate film may be provided where increased protection is desired.

Laminates in which a relatively thin intermediate film remains over the photoresist after removal of a relatively thick support sheet provide substantially better resolution than conventional dry films of the type in which a support sheet is in direct contact with the photoresist layer and in which the photoresist layer must be protected by the support sheet during exposure. Generally resolution is limited by the collective thicknesses of the layers, including the photoresist, through which the actinic radiation passes during exposure. Thus, an uncovered 2 mil resist layer can be expected to resolve 2 mil lines; if a 2 mil support sheet covers the 2 mil resist, resolution is reduced to at least about 4 mil lines. On the other hand, if during exposure, only a thin protective film or top sheet 0.1 mil thick, covers the photoresist, there is minimal loss of resolution relative to that which can be expected from an unprotected resist. A support sheet which is to provide both mechanical support and protection, e.g., from oxygen, must have a certain thickness to provide the requisite mechanical support. On the other hand, a thin intermediate film, which becomes a protective top sheet only after the laminate is applied to a substrate and the support sheet removed, need supply no mechanical support to the photoresist layer, and therefore may be as thin as is consistent with its protective requirement. Generally, intermediate films are 0.5 mil or thinner and usually 0.1 mil or thinner, whereas a typical PET support sheet in a conventional dry film is about 0.90 mil or thicker.

Furthermore, CPVA and CPVA/HEC films contribute to resolution in that they diffract light and pipe light less than most support sheet materials, such as PET.

In accordance with a preferred aspect of the invention, the CPVA used in the intermediate film is admixed with up to about 90% HEC. Although CPVA is suitable in itself as an intermediate film in a laminate, being selectively adherent to a resist layer at room temperature, it tends to stick to the support sheet at elevated temperatures such as the temperatures whereat the resist layer is bonded to the substrate. Accordingly, it preferred to cool the laminate and adhered substrate before removing the support sheet.

CPVA/HEC films have improved selective adherance to photoresists relative to straight CPVA films. In particular, mixtures of CPVA and HEC tend to separate more readily from the support layer at elevated temperatures than does straight CPVA, HEC generally having a lower adhesion to support layer materials, such as PET. In addition, HEC is substantially less expensive than CPVA, and admixture of HEC reduces the cost of producing the laminate.

HEC is a derivative of cellulose formed by reacting ethylene oxide with cellulose. The ethylene oxides join to the active hydroxyl groups of anhydrogluclose units or to hydroxyl groups derived from the already added ethylene oxide. HEC's used in in accordance with the invention have between about 1 and about 3 units of ethylene oxide per anhydroglucose unit, about 2.5 being preferred. Viscosities of a 2% HEC solution at 25°C range from about 25 to about 6500 cps and preferably between about 500 and about 1100 cps. A suitable HEC for use in the present invention is sold under the trade designation Natrosol 250 LR by Hercules.

HEC in itself has many desirable attributes of an intermediate film; however, HEC lacks flexibility.

CPVA provides the flexibility of a CPVA/HEC mixture as required for forming rolls of the laminate and also for application to flexible substrate material. As noted above, the HEC facilitates elevated temperature removal of the support sheet from the intermediate film. The weight percentage of HEC ranges from 0 to about 90%, depending on the desired properties of the intermediate film, particularly in respect to adherence to the particular support sheet material but also in respect to adherence to the particular resist layer. From the standpoint of separability from the support sheet at elevated temperatures, it is generally preferred to use HEC at at least about a 25 weight percent level. From a cost perspective, it is generally preferred to use HEC at at least about a 50 weight percent level. Generally, about 90 weight percent is the upper limit of HEC or the intermediate film is too brittle. It should be noted that whereas a CPVA/HEC mixture is found to be particularly suitable as an intermediate film, HEC and PVA are found to be mutually incompatible. The enhanced hydrophilicity of CPVA relative to PVA enables CPVA and HEC to be admixed substantially throughout the entire range of relative weight percentages.

In accordance with a further aspect of this invention, the intermediate film (or top coat) may contain up to about 10 wt. percent of a plasticizer. A plasticizer tends to lower the tack temperature of the composition, and tack temperatures below about 100°C have been achieved using such plasticizers. A composition having a lower tack temperature is easier to adhere to the photoresist layer. With an intermediate film having a lower tack temperature, during lamination of the photoresist to copper, the entire laminate conforms better to irregularities in the copper at lower temperatures. Also, during development, plasticized top coat is more easily removed because of increased wetting action. Even with plasticizer, the intermediate film (top coat) is sufficiently non-sticking to commonly used phototools. Preferred plasticizers are low molecular weight, e.g., below about 200, compounds having two or more hydroxyl groups, such as glycerine, ethylene glycol, and propylene glycol. While plasticizers desirably lower the tack temperature, they also increase oxygen permeability or the intermediate layer (top coat); accordingly, amounts of plasticizer in excess of about 10% by weight are desirably avoided.

CPVA and CPVA/HEC mixtures can be used to form very thin, yet sufficiently strong films, thereby improving both photospeed and resolution. These materials are confirmed to be functional in resolving 2.0 mil line and spaces for 2 mil resists. Not only are these materials generally impermeable to gases, such as oxygen, but they also inhibit monomer migration from the photoresist and cold flow, relative to a PVA layer. Improved sidewall formation, both of the developed photoresist composition and of the etched metal layer, are exhibited using CPVA or CPVA/HEC as intermediate film.

In accordance with a preferred aspect of the present invention, CPVA or CPVA/HEC intermediate films are most advantageously used in conjunction with support sheets having hydrophilic surfaces. Preferably, if a polyester is used, e.g., Mylar, it surface-activated, e.g., by flame treatment or chemical treatment, to increase the wetting angle (hydrophilicity). Preferably, the wetting or contact angle of the support sheet material is at least about 60°. Preferably, the wetting angle is 75° or less. One suitable support sheet is sold under the trade designation Melinex-393 by ICI, which is a polyester that is surface-treated on the photoresist side to enhance its hydrophilicity, i.e., increase its wetting angle.

Represented in Figure 4 is an alternative embodiment of a laminate L$_A$ in accordance with the present invention. In this case, the CPVA or CPVA/HEC top sheet layer or film 31 is coated on resist layer 32, which, in turn, is coated on a support sheet 33. The support sheet 33 is selected of a material which is loosely adherent to the resist layer but non-adherent to the CPVA or CPVA/HEC layer, whereby the laminate L$_A$ may be wound into a roll. The support sheet 33 is removed from the resist layer 32 before the top sheet/resist laminate is applied to a substrate.

The invention will now be described in greater detail by way of specific examples.

Example 1

Solutions A and B are prepared containing the following materials in the proportions indicated:

| Material | A (wt. Percent) | B (wt. percent) |
|---|---|---|
| Deionized water | 67.06 | 67.06 |
| Carboxylated Polyvinyl Alcohol V118M | 8.09 | 0.81 |
| Pluronic L-61 (poly-oxelene, a non-ionic surfactant polymer) | 0.05 | 0.05 |
| Isopropanol | 24.80 | 24.80 |
| Natrosol 250 LR (hydroxyethyl cellulose) | ——— | 7.28 |

Each solution A and B is coated onto the treated surface of ICl-393 polyester support layer 1 and dried fully at elevated temperature to provide a 0.1 mil thick film 2. On different specimens of each of A-coated and B-coated polyether is applied a 2 mil layer 3 of the following resists: Laminar ML(aqueous), Laminar HG (aqueous), Laminar TR (aqueous), Laminar TA (aqueous), Laminar AX (semi-aqueous) and Laminar Visible Laser Resist (aqueous). Finally, a polyethylene cover sheet 20 is laminated over the resist to provide a Laminar L'.

Example 2

Various materials were examined for suitability as intermediate films of top sheets 2. The results are given in Table 1 below:

## TABLE 1

### POLYMERS TESTED FOR TOP SHEET

| POLYMERS | FILM FORMER | PREVENT MONOMERS MIGRATION | SELECTIVE ADHERENCE | FLEXIBILITY |
|---|---|---|---|---|
| Gelvatol 20-90 (PVA) | Yes | Yes | Reasonable | Excellent |
| Vinol 118M (PVA) | Yes | Yes | Reasonable | Excellent |
| Elvanol HB (PVA) | Yes | Yes | Reasonable | Excellent |
| Vinol V318 (CPVA) | Yes | Yes | Reasonable | Excellent |
| Natrosol 25OLR (Hydroxyethyl Cellulose) | Yes | Yes | Excellent | Poor |
| Cellosize (Hydroxyethyl Cellulose) | Yes | Yes | Excellent | Poor |
| Klucel E; G & L (Hydroxypropyl Cellulose) | Yes | No | Poor | Good |
| Scripset 540 (Styrene-Maleic Anhydride) | Yes | No | Poor | Reasonable |
| Carboset 526 and 525 (Acrylic Copolymer) | Yes | No | Poor | Good |
| ASB (Polyvinyl Acetate) | Yes | No | Poor | Reasonable |
| Joncryl 67 (Acrylic Copolymer) | No | No | Poor | Poor |

## TABLE 1 (Cont'd)

### POLYMERS TESTED FOR TOP SHEET (Cont'd)

| POLYMERS | SOLUBILITY IN BASIC DEVELOPER | STICK TO ARTWORK | HIGH SOFTEN POINT 235°F+ | LIGHT-TRANSMITTING |
|---|---|---|---|---|
| Gelvatol 20-90 (PVA) | Poor | No | Yes | Yes |
| Vinol 118M (PVA) | Poor | No | Yes | Yes |
| Elvanol HB (PVA) | Poor | No | Yes | Yes |
| Vinol V318 (CPVA) | Excellent | No | Yes | Yes |
| Natrosol 250LR (Hydroxyethyl Cellulose) | Excellent | No | Yes | Yes |
| Cellosize (Hydroxyethyl Cellulose) | Excellent | No | Yes | Yes |
| Klucel E; G & L (Hydroxypropyl Cellulose) | Good | Yes | Yes | Yes |
| Scripset 540 (Styrene-Maleic Anhydride) | Excellent | Yes | Yes | Yes |
| Carboset 526 and 525 (Acrylic Copolymer) | Excellent | Yes | No | Yes |
| ASB (Polyvinyl Acetate) | Excellent | Yes | Yes | Yes |
| Joncryl 67 (Acrylic Copolymer) | Excellent | Yes | Yes | Yes |

9

TABLE 1 (Cont'd)

POLYMERS TESTED FOR TOP SHEET (Cont'd)

| POLYMERS | FILM FORMER | PREVENT MONOMERS MIGRATION | SELECTIVE ADHERENCE | FLEXIBILITY |
|---|---|---|---|---|
| Morez 85-7797 (Acrylic) | No | No | Poor | Poor |
| Carbopol 910, 907, 901 (Acrylic Copolymer) | Yes | No | Poor | Good |
| PVP K-66 (Polyvinylpyrrolidone) | Yes | No | Poor | Poor |
| Methocel 815, A4C (Cellulose Ether) | Yes | No | Poor | Poor |

| POLYMERS | SOLUBILITY IN BASIC DEVELOPER | STICK TO ARTWORK | HIGH SOFTEN POINT 235°F | LIGHT-TRANSMITTING |
|---|---|---|---|---|
| Morez 85-7797 (Acrylic) | Excellent | Yes | Yes | Yes |
| Carbopol 910, 907, 901 (Acrylic Copolymer) | Excellent | Yes | Yes | Yes |
| PVP K-66 (Polyvinylpyrrolidone) | Excellent | Yes | Yes | Yes |
| Methocel 815, A4C (Cellulose Ether) | Good | Yes | Yes | Yes |

Example 3

Various sheet materials were tested for use as support sheets 1. The results are given in Table 2 below:

## TABLE 2

### SUPPORT SHEET TESTED FOR PHOTORESISTS
### USING LAMINAR HG

| SUPPORT SHEET | S/H | H/R | CONTACT ANGLE FOR D.I. $H_2O$ |
|---|---|---|---|
| ICI-393 (Treated PET) | Ex | Ex | 64° |
| ICI-313 (Treated PET) | Ex | Ex | 66° |
| Mylar 50 M-24 | Ex | Ex | 72° |
| Mylar 50 M-25 | Re | Ex | 68° |
| Mylar 50 M-30 | Poor | Ex | 82° |
| PET with Silicone | Poor | Ex | 95° |
| PET with PTFE* | Ex | Ex | 98° |
| H.P. Smith Release Paper 53# Bl. | Ex | Poor | 97° |
| H.P. Smith Release Paper 63# Bl. | Ex | Poor | 98° |
| H.P. Smith Release Paper 72# Bl. | Poor | Poor | 96° |
| H.P. Smith Release Paper 83# Bl. | Ex | Poor | 93° |

## TABLE 2 (Cont'd)

### SUPPORT SHEET TESTED FOR PHOTORESISTS USING LAMINAR HG

| SUPPORT SHEET | S/H | H/R | CONTACT ANGLE FOR D.I. $H_2O$ |
|---|---|---|---|
| H.P. Smith Release Paper 76# Bl. | Poor | Poor | 92° |
| H.P. Smith Release Paper 92# Bl. | Poor | Poor | 91° |
| H.P. Smith Release Paper 83# Tan | Ex | Poor | 90° |
| H.P. Smith Release Paper 92# Tan | Poor | Poor | 90° |
| H.P. Smith Release Paper 96# Tan | Poor | Poor | 92° |
| Schoeller VR Silicone | Poor | Good | 90° |

```
S/H  = Selective Adherence
H/R  = Heat Resistance
Ex   = Excellent
Re   = Reasonable
PTFE = Poly(tetrafluoro ethylene)
```

EXAMPLE 4

An intermediate layer or top coat was formulated as follows:

0 267 807

|  | gm | wt% |
|---|---|---|
| Deionized water | 2310.1 | 70.04 |
| Isopropyl alcohol | 690.0 | 20.92 |
| HEC (Natrosol 250LR) | 240.0 | 7.28 |
| Pluronic L-61 | 1.6 | 0.05 |
| CPVA (Vinol-118M) | 26.7 | 0.81 |
| Glycerin | 29.6 | 0.90 |
|  | 3298.0 | 100.00 |

This formulation has a tack temperature below 100°C.

While the invention has been described in terms of certain preferred embodiments, modifications obvious to one with ordinary skill in the art may be made without departing from the scope of the invention. For example, although the laminate in accordance with the present invention is described as comprising a photoresist layer, an intermediate film and a support sheet, additional layers which serve various purposes, such as provide additional protection or which provide opaqueness prior to exposure, are considered to be within the scope of the present invention.

Various features of the invention are set forth in the following claims.

**Claims**

1. A photosensitive laminate comprising a layer (3) of photoresist, and a film (2) adhered to said photoresist layer formed of between 10 weight percent and 100 percent carboxylated polyvinyl alcohol and up to 90 weight percent of hydroxyethyl cellulose.

2. A photosensitive laminate comprising a layer photoresist, an intermediate film (2) formed of between 10 weight percent and 100 percent carboxylated polyvinyl alcohol and up to 90 weight percent of hydroxyethyl cellulose, and a support sheet (1) formed of a material which adheres to said intermediate film but with less relative adherence to said intermediate film than the adherence between said intermediate film and said photoresist layer.

3. A laminate in accordance with Claim 2 wherein said intermediate film (2) comprises between 10 and 75 weight percent of carboxylated polyvinyl alcohol and between 25 and 90 weight percent hydroxyethyl cellulose.

4. A laminate in accordance with claim 2 or claim 3 wherein said carboxylated polyvinyl alcohol is a hydrolyzed copolymer of vinyl acetate and acylic ester, between 1 and 5 percent of the mer units of said copolymer being derived from acrylic acid, said copolymer being at least 75% hydrolyzed.

5. A laminate in accordance with any one of claims 2 to 4 wherein said support sheet (1) is formed of a polyester.

6. A laminate in accordance with any one of claims 2 to 5 wherein said support sheet (1) is surface-treated to have a wetting angle of 75° or less.

7. A laminate in accordance with with any one claims 1 to 5, wherein said photoresist layer (2) is developable in basic aqueous or semi-aqueous solution.

8. A laminated photosensitive composite comprising a substrate (5), a layer (3) of photoresist, and a top sheet (2) formed of between 10 weight percent and 100 percent carboxylated polyvinyl alcohol and up to 90 weight percent of hydroxyethyl cellulose.

9. A process of producing an image on a substrate comprising providing a photosensitive laminate (L) comprising (a) a layer (3) of photoresist and (b) a top sheet (2) formed of between 10 weight percent and 100 weight percent carboxylated polyvinyl alcohol and up to 90 weight percent of hydroxyethyl cellulose, applying said laminate to said substrate by adhering said layer of photoresist to said substrate so as to form a composite (C) of said substrate, said layer of photoresist and said top sheet, exposing said composite to patterned actinic radiation, removing said top sheet with an aqueous or semi-aqueous solution and developing said composite to remove soluble portions of said photoresist layer, and appropriately treating portions of said substrate from which said photoresist layer is removed to provide said image thereon.

10. A process of producing an image on a substrate comprising providing a photosensitive laminate comprising (a) a layer of photoresist (3) which subsequent to exposure to patterned radiation has a

13

portion that is soluble in a developer comprising a basic aqueous solution and a portion that is insoluble in a developer comprising a basic aqueous solution, (b) an intermediate film (2) formed of between about 10 weight percent and 100 percent carboxylated polyvinyl alcohol and up to about 90 weight percent of hydroxyethyl cellulose, and (c) a support sheet (1) formed of a material which adheres to said intermediate film but with less relative adherence to said intermediate film than the adherence between said intermediate film and said photoresist layer, applying said laminate to said substrate (5) by adhering said layer of photoresist to said substrate, either before or after exposing said composite, removing said support sheet from said intermediate film, leaving a composite (C) of said substrate, said layer of photoresist and said intermediate film, exposing said composite to patterned light radiation, developing said composite with a developer comprising a basic aqueous solution, thereby dissolving said intermediate film and base-soluble portions of said exposed photoresist layer from said substrate, and appropriately treating portions of said substrate from which said photoresist layer is removed to provide said image thereon.

Fig. 1

Fig. 2

Fig. 3

Fig. 4

0267807